# EUROPÄISCHE PATENTSCHRIFT

(11) **EP 1 186 175 B1**
(45) Veröffentlichungstag und Bekanntmachung des Hinweises auf die Patenterteilung: **12.02.2003**
(21) Anmeldenummer: 00941903.7
(22) Anmeldetag: 05.05.2000
(51) Int. Cl.: H04N 7/26, H04N 7/48

(54) **VERFAHREN UND VORRICHTUNG ZUR KOMPRIMIERUNG UND DEKOMPRIMIERUNG VON DATEN**
METHOD AND DEVICE FOR COMPRESSING AND DECOMPRESSING DATA
PROCEDE ET DISPOSITIF DE COMPRESSION ET DE DECOMPRESSION DE DONNEES

(30) Priorität: 07.05.1999 DE 19921298
(43) Veröffentlichungstag der Anmeldung: 13.03.2002
(73) Patentinhaber: ROBERT BOSCH GMBH, 70442 Stuttgart (DE)
(72) Erfinder: MEROTH, Ansgar, D-72766 Reutlingen (DE); GEISLER, Thomas, D-76137 Karlsruhe (DE)
(86) Internationale Anmeldenummer: DE0001411
(87) Internationale Veröffentlichungsnummer: WO00069179

(56) Entgegenhaltungen:
- EP-A- 0 766 469
- EP-A- 0 810 532
- WO-A-96/11546
- US-A- 4 937 681

## Beschreibung

### Stand der Technik

Die Erfindung geht aus von einem Verfahren zur Komprimierung von Daten nach der Gattung des Hauptanspruchs. Mit dem Run-Length-Encoding-Verfahren (RLE-Verfahren) ist bereits ein Verfahren zur Komprimierung von Daten bekannt, bei dem kein Datenverlust auftritt. Dieses Verfahren wird z.B. bei sogenannten PCX-Dateien verwendet. Gegenstand des Verfahrens ist es, sich wiederholende Datenelemente zusammenzufassen und mit der Anzahl der Wiederholungen zu speichern. Sind die Datenelemente Bytes aus acht Bits, so erfolgt die Komprimierung in der Weise, daß Bytes, die sich nicht wiederholen, bis zu einem Wert von 63 unkomprimiert gespeichert werden, wobei die obersten beiden Bits den Wert 0 besitzen müssen. Bytes mit dem Wert zwischen 64 und 255, sowie Bytes zwischen 0 und 63, die sich wiederholen, werden kodiert in einem Datenelement aus zwei Bytes gespeichert. In dem ersten Byte sind in diesem Fall die obersten beiden Bits eins gesetzt. Die folgenden Bits geben den Wiederholungsfaktor für das zweite Byte an. Bei diesem Verfahren ist es nachteilig, daß sich für einzelne Bytes mit einem Wert zwischen 64 und 255 der Speicherplatzbedarf verdoppelt. In einem ungünstigen Fall kann durch die Komprimierung nach dem RLE-Verfahren somit der benötigte Speicherplatz nach der Komprimierung größer sein als vor der Komprimierung. Ferner ist für eine Datenkomprimierung noch der Lempel-Ziv Algorithmus bekannt, bei dem eine zu komprimierende Datenfolge auf Wiederholungen von Teilfolgen hin untersucht wird, sich wiederholende Elemente in einer Codetabelle gespeichert werden und eine Ersetzung der Teilfolgen durch ein zugewiesenes Codezeichen erfolgt. Zur Dekomprimierung muß eine Tabelle unbekannter Größe angelegt werden.

### Vorteile der Erfindung

Das erfindungsgemäße Verfahren mit den Merkmalen des Hauptanspruchs hat dem gegenüber den Vorteil, daß die Information, ob ein Datenelement komprimiert oder unkomprimiert abgespeichert ist, in einem weiteren, zusätzlichen Datenelement gespeichert wird. Hierdurch ist es möglich, das erfindungsgemäße Komprimierverfahren für alle Datenelemente unabhängig von ihrem Wert anzuwenden, da in die einzelnen Datenelemente selbst keine zusätzliche Komprimierungsinformation aufgenommen werden muß. Ferner ist es von Vorteil, die Komprimierung von vorhergehenden und nachfolgenden Datenelementen abhängig zu gestalten, da hierdurch eine besonders effektive Komprimierung möglich ist. Weiterhin ist es vorteilhaft, die komprimierten oder unkomprimierten Datenelemente in einem dafür vorgesehenen Speicherbereich und das Datenelement, in dem gespeichert ist, welche Datenelemente komprimiert oder unkomprimiert abgespeichert sind, in einem weiteren Speicherbereich abzulegen, da durch diese Speicherung ein effektiverer Zugriff auf die Datenelemente möglich ist.

Durch die in den Unteransprüchen aufgeführten Maßnahmen sind vorteilhafte Weiterbildungen und Verbesserungen des im Hauptanspruch angegebenen Verfahrens möglich. Besonders vorteilhaft ist es, daß mehrfach aufeinanderfolgende, gleiche Datenelemente gezählt und mit einem Wiederholungsfaktor in der erfindungsgemäßen Weise gespeichert werden. Der Wiederholungsfaktor kann dabei einen Maximalwert des Datenelements annehmen, da die Information, ob das Datenelement komprimiert oder unkomprimiert gespeichert ist, in einem anderen Datenelement gespeichert wird. Ferner ist es von Vorteil, bei Folgen von Datenelementen, die eine vorgebbare Größe überschreiten, eine Speicherung in verschiedenen Datenpaketen vorzunehmen. Hierdurch können auch Grafiken, die sehr viel Speicherplatz benötigen, in Datenpakete zerlegt werden, deren Größe z.B. optimal an die Sektorengröße eines Datenträgers oder die Datenpaketgröße für die Übertragung über eine Schnittstelle oder über das Internet, z.B. per E-mail, angepaßt sind.

Besonders vorteilhaft ist es weiterhin, ein Verfahren zur Dekomprimierung der erfindungsgemäß komprimierten Datenelemente vorzusehen. Das Dekomprimierverfahren hat dabei den Vorteil, daß die in einem ersten Bereich abgelegten Datenelemente Informationen darüber enthalten, welche der in dem zweiten Bereich abgelegten Datenelemente komprimiert oder unkomprimiert abgelegt sind. Gegenüber dem Stand der Technik ist damit eine einfachere Bearbeitung der Daten möglich, da z.B. bei dem RLE-Verfahren für PCX-Dateien eine derartige Trennung nicht möglich ist und die Information, ob ein Datenelement komprimiert oder unkomprimiert abgelegt ist, direkt mit diesem Datenelement gespeichert wird.

Weiterhin ist es vorteilhaft, eine Dekomprimierung aus mehreren, miteinander verknüpften Datenpaketen vorzunehmen, da auf diese Weise die aus den Datenpaketen gewonnene Datenfolge eine beliebige Größe annehmen kann.

Es ist ferner vorteilhaft, das genannte Verfahren vorzugsweise zur Komprimierung bzw. Dekomprimierung von Bilddaten zu verwenden. Für eine Dekomprimierung ist es dabei vorteilhaft, eine Vorrichtung vorzusehen, die mit einer Recheneinheit und einer Anzeigevorrichtung verbunden ist. Durch das schnelle und speicherplatzgünstige Dekomprimierverfahren ist es dabei möglich, die in einer Speichereinheit gespeicherten Informationen, wobei z.B. die Speichereinheit ein Teil der Recheneinheit ist, durch eine Dekomprimiereinheit auszulesen und mit Hilfe der Anzeigevorrichtung darzustellen. Eine besonders vorteilhafte Verwendung ist es dabei, die Dekomprimiervorrichtung für ein frei programmierbares Kombiinstrument in einem Kraftfahrzeug vorzusehen. Denn insbesondere für die Instrumentenanzeige in einem Kraftfahrzeug muß allein schon aus Gründen der Übersichtlichkeit eine grafische Darstellung mit möglichst einfacher Struktur gewählt werden. Durch diese einfache Struktur der anzuzeigenden Bilddaten sind Wiederholungen gleicher Bildelemente und damit auch Wiederholungen gleicher Datenelemente besonders häufig. Das erfindungsgemäße Komprimier- und Dekomprimierverfahren kann daher besonders effizient eingesetzt werden. Hierdurch können sowohl der Speicherplatzbedarf, als auch die dadurch hervorgerufenen Kosten für ein frei programmierbares Kombiinstiument gesenkt werden. Ferner werden für die Speicherung von Bildern in einem frei programmierbaren Kombiinstrument im allgemeinen relativ langsame Speicher verwendet. Bei hochkomprimierten Bildern wirkt sich die Speicherzugriffszeit jedoch deutlich weniger aus, als bei Bildern, die unkomprimiert abgespeichert sind. Komprimierte Bilder können folglich bei hinreichend hoher Rechenleistung bei einem langsamen Speicher schneller angezeigt werden als unkomprimierte Bilder, da für diese ein größerer Speicherbereich . erforderlich ist.

Weiterhin ist es von Vorteil, daß als Grundelement ein einzelnes Bit gewählt wird, durch das festgelegt wird, ob ein Datenelement komprimiert oder unkomprimiert gespeichert ist. Hierdurch nimmt in der Worst-Case-Betrachtung pro unkomprimiertem Datenelement die Datenmenge nur um ein Bit zu. Dagegen tritt bei dem im Stand der Technik genannten RLE-Verfahren für PCX-Dateien eine Zunahme der Datenmenge bei unkomprimiert gespeicherten Datenelementen um ein Byte, also um acht Bit, auf. Eine Zwischenspeicherung z.B. in Form einer Codetabelle, wie sie bei dem Lempel-Ziv-Algorithmus erforderlich ist, wird nicht benötigt. Für die Dekomprimierung sind zwei Register ausreichend: Ein erster Register für ein zu dekomprimierendes Datenelement und ein zweiter Register für das Datenelement, in dem abgelegt ist, ob das Datenelement in dem ersten Register komprimiert abgelegt ist. Ein darüber hinausgehender, flüchtiger Speicher ist nicht erforderlich.

US-A-4,937,681 beschreibt ein Verfahren zur Kompression von Dokumenten, die neben Text auch Bildelemente beinhalten können. In der Beschreibung des Stands der Technik in US-A-4,937,681 werden Methoden (z.B. MR oder MH Kodierung) genannt, die es ermöglichen innerhalb eines Datenstroms Pixelinformationen in komprimierter, sowie unkomprimierter Form zu übertragen. Innerhalb des Datenstroms befinden sich zusätzliche Identifikationswörter, mit Hilfe derer die Folge von Datenelementen, die entweder in komprimierter oder unkomprimierter Darstellung vorliegen, getrennt werden. Zur Vermeidung einer unerwünschten Vergrößerung der Datenmenge bei ungünstigen Datenkonstellationen werden verschiedene Methoden angewandt, die die Abhängigkeit von Korrelationen zwischen den Daten beobachtet und über die Verwendung eines der jeweiligen komprimierenden oder nicht komprimierenden Modi entscheidet.

EP-A-0 810 532 spezifiziert ein System zur Komprimierung von Datenelementen, die über einen bandbegrenzten Kanal übertragen und auf der Empfangsseite dekomprimiert werden. Die komprimierten Datenelemente bilden ein Datenpaket, das aus einem ersten und einem zweiten Bereich besteht, wobei die Grundelemente (Bits) der Datenelemente (Bytes) des ersten Bereichs festlegen, ob die Datenelemente des zweiten Bereichs mit oder ohne Komprimierung erstellt werden, wobei beginnend von einem leeren Feld eine Datenfolge bis zum Erreichen eines Abbruchkriteriums aufgebaut wird. Die jeweils komprimierten Datenelemente im zweiten Bereich bestehen dabei aus dem Deltawert (Differenz) zweier aufeinanderfolgender Datenelemente. Die komprimierte Datenfolge wird dekomprimiert, indem die Datenelemente des zweiten Datenbereichs in Abhängigkeit der Bits der Datenelemente des ersten Datenbereichs entweder direkt übernommen oder dekomprimiert werden. Dieses System enthält einen Datenprozessor, der mit einer Anzeigeeinheit zur Visualisierung der übertragenen Datenelemente verbunden ist (EKG-Wellenverläufe).

### Zeichnungen

Ausführungsbeispiele der Erfindung sind in der Zeichnung dargestellt und in der nachfolgenden Beschreibung näher erläutert. Es zeigen Figur 1 eine Struktur eines erfindungsgemäßen Datenpakets, Figur 2 eine erfindungsgemäße Ausführung eines Datenpaktes, Figur 3 eine erfindungsgemäße Vorrichtung zur Dekomprimierung mit einer angeschlossenen Anzeigevorrichtung und einer Recheneinheit, Figur 4 einen erfindungsgemäßen Verfahrensablauf zur Komprimierung einer Folge von Datenelementen, Figur 5 einen erfindungsgemäßen Verfahrensablauf zur Dekomprimierung eines Datenpakets.

### Beschreibung des Ausführungsbeispiels

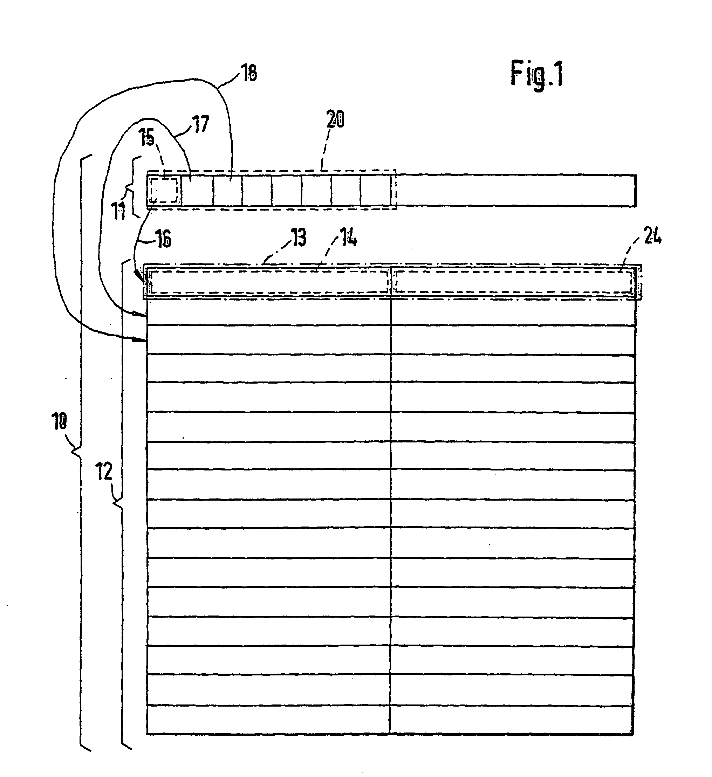

In Figur 1 ist ein Datenpaket 10 dargestellt, das in erfindungsgemäßer Weise komprimierte Daten enthält. Die Ausführung des Datenpakets in Figur 1 ist ein Beispiel für die Struktur eines gespeicherten Datenpaketes 10. Das Datenpaket 10 verfügt über einen ersten Bereich 11 und einen zweiten Bereich 12. Der zweite Bereich 12 besteht aus mindestens einem Wort 13. Dabei besteht ein Wort 13 aus einem ersten Datenelement 14 und einem zweiten Datenelement 24. Für die Darstellung in der Figur 1 wurde ein Wort 13 mit zwei Datenelementen 14 und 24 in dem zweiten Bereich 12 hervorgehoben.

In dem Ausführungsöeispiel besteht auch der erste Bereich 11 aus einem Wort mit zwei Datenelementen. Die Datenelemente sind dabei in Grundelemente unterteilbar. In der Figur 1 ist ein Datenelement 20 in eine Vielzahl einzelner Grundelemente 15 aufgegliedert dargestellt. Ein Grundelement 15 ist in der Zeichnung durch eine gestrichelte Umrahmung hervorgehoben. Jedes Grundelement 15 der Datenelemente in dem ersten Bereich 11 ist eindeutig einem Wort 13 in dem zweiten Bereich 12 zugewiesen. In der Figur sind beispielhaft drei Zuweisungen 16, 17 und 18 zwischen Grundelementen im ersten Bereich 11 und Wörtern im zweiten Bereich 12 dargestellt. Anhand des hervorgehobenen Grundelements 15 und des hervorgehobenen Wortes 13 wird die Zuweisung erläutert: Je nach Wert des Grundelements 15 liegt das zugehörige Wort 13 komprimiert oder unkomprimiert vor. Liegt es unkomprimiert vor, so sind die beiden Datenelemente 14, 24 des zugehörigen Wortes 13 unkomprimierte Datenelemente einer ursprünglich zu komprimierenden Folge von Datenelementen. Liegt dagegen das Wort 13 komprimiert vor, so beinhaltet das zugehörige erste Datenelement 14 einen Wiederholungsfaktor dafür, wie oft nun das zweite Datenelement 24 bei einer Dekomprimierung, die eine Wiederherstellung der ursprünglichen Datenfolge zum Ziel hat, wiederholt werden soll.

Die Datenelemente in dem ersten Bereich 11 und dem zweiten Bereich 12 sind vorzugsweise gleichartig und haben die gleiche Größe. Dies ist jedoch nicht notwendigerweise erforderlich. So können z.B. die Datenelemente in dem zweiten Bereich eine anders geartete Aufteilung in Grundelemente aufweisen, als sie in dem ersten Bereich 11 erfolgt.

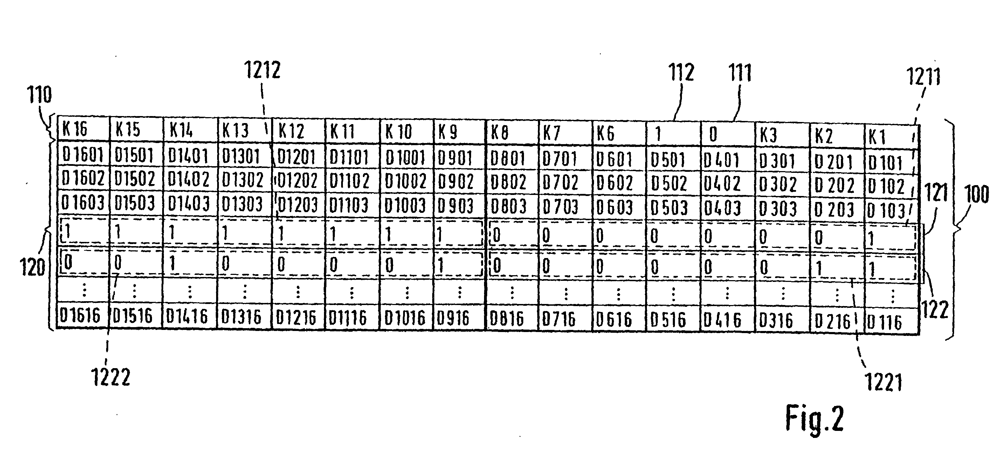

In Figur 2 ist ein Datenpaket 100 dargestellt, das eine spezielle Realisierung des Datenpakets 10 aus Figur 1 darstellt. Das Datenpaket verfügt über einen ersten Bereich 110 und einen zweiten Bereich 120. Der erste Bereich 110 und der zweite Bereich 120 bestehen jeweils aus gleichartigen Wörtern, die alle wiederum aus jeweils zwei Datenelementen bestehen. Die zu einem Wort gehörenden Datenelemente sind in der Figur nebeneinander angeordnet. Jedes Datenelement besteht wiederum aus acht Bits. Jedes Bit kann entweder einen Wert "0" oder einen Wert "1" annehmen.
Der erste Bereich 110 umfaßt in dem Ausführungsbeispiel genau ein Wort. Der zweite Bereich umfaßt 16 Worte, von denen aus Gründen der Übersichtlichkeit nicht alle in der Figur dargestellt sind. Die Bits in dem ersten Bereich 110 sind mit den Bezeichnungen K1 bis K16, die Bits in dem zweiten Bereich sind mit Bezeichnungen zwischen D101 bis D1616 angegeben, falls ihr Wert nicht explizit angegeben ist. Dabei beziehen sich die letzten beiden Stellen der Bezeichnungen D101 bis D1616 auf eine Zuordnung zu einem der Bits K1 bis K16. Der Wert dieser Bits kann beliebig entweder "1" oder "0" sein.
Ein erstes Grundelement 111 in dem ersten Bereich 110 mit einem zugehörigen ersten Wort 121 mit einem ersten Datenelement 1211 und einem zweiten Datenelement 1212 in dem zweiten Bereich 120 sind explizit angegeben. Ferner ist ein zweites Grundelement 112 in dem ersten Bereich mit einem zugehörigen zweiten Wort 122 aus dem zweiten Bereich 120 mit einem ersten Datenelement 1221 und einem zweiten Datenelement 1222 explizit angegeben.

Die einzelnen Bits eines Datenelementes, zum Beispiel des zweiten Datenelements 1222 können als einzelne Ziffern einer Dualzahl interpretiert werden. So läßt sich offenbar jedem Datenelement eine ganze Zahl im Bereich von Null bis 255 zuordnen (255 = 2⁸-1). Dem zweiten Datenelement 1222 läßt sich damit offenbar die Zahl 33 zuordnen. Ferner ist es möglich, zum Beispiel über den ASCII-Code, den ANSI-Code oder einen beliebigen anderen Code dieser Zahl wiederum ein Schrift- oder Bildschirmzeichen zuzuweisen.

In dem gewählten Ausführungsbeispiel hat nun das Grundelement 111 in dem ersten Bereich 110 den Wert Null. In dem gewählten Ausführungsbeispiel bedeutet dies, daß das zugehörige Wort 121 als unkomprimiert aufzufassen ist. Dies bedeutet, daß die Datenelemente 1211 und 1212 nicht komprimiert sind. Bei der Wiederherstellung der Datenfolge im Rahmen einer Dekomprimierung des Datenpaketes 100 wird an dieser Stelle nun zunächst das Datenelement 1211 mit dem Wert 1 bzw. 00000001 als Dualzahl der bis zu diesem Zeitpunkt erstellten Datenfolge zugefügt. Anschließend wird das Datenelement 1212 mit dem Wert 255 bzw. 11111111 als Dualzahl der bisher erstellten Datenfolge zugefügt.

Das zweite Grundelement 112 hat in dem gewählten Ausführungsbeispiel den Wert 1. Deshalb ist das zweite Wort 122 als komprimiert aufzufassen. In diesem Fall gibt das zweite Datenelement 1222 den Wiederholungsfaktor für das erste Datenelement 1221 vor. Da dem zweiten Datenelement 1222 der Wert 33 zugewiesen ist, bedeutet dies, daß das erste Datenelement 1221 bei der Dekomprimierung der Daten 33 Mal an die bis zu diesem Zeitpunkt bereits erstellte Teilfolge anzuhängen ist. Anschließend wird mit dem mit K6 bezeichneten Grundelement in dem ersten Bereich 110 und dem zugehörigen, in der Zeichnung nicht dargestellten Wort weiter verfahren, bis das Datenpaket vollständig bearbeitet und die ursprüngliche Datenfolge wiederhergestellt ist.

Dabei ist es ebenfalls möglich, das erste Datenelement 1221 als Wiederholungsfaktor für das zweite Datenelement 1222 zu betrachten. Vor einer Komprimierung bzw. Dekomprimierung ist dies eindeutig festzulegen.

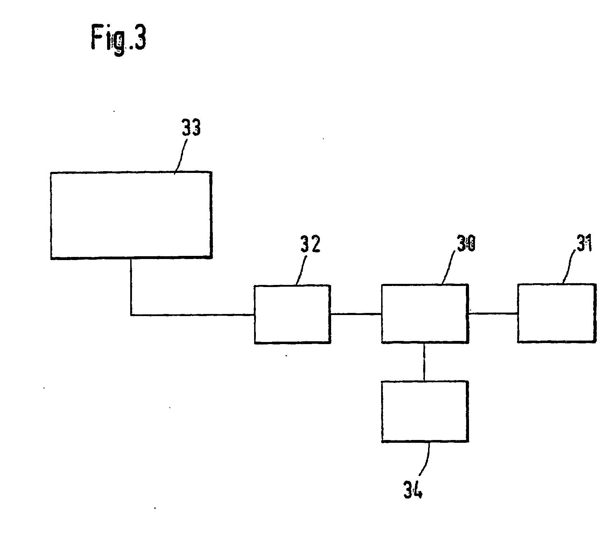

In der Figur 3 ist eine Vorrichtung zur Dekomprimierung 30, mit der das erfindungsgemäße Verfahren ausführbar ist, in Verbindung mit einer Recheneinheit 31, einem Speicher 34, einem Bildspeicher 32 und einer Anzeigeeinheit 33 dargestellt. Dieses gewählte Ausführungsbeispiel ist vorzugsweise in einem Kraftfahrzeug einsetzbar und dient insbesondere der Anzeige von Betriebsdaten des Fahrzeuges. Über die Recheneinheit 31 werden über nicht eingezeichnete Sensoren und Meßinstrumente zum Beispiel die Motordrehzahl, die Kühlwassertemperatur und/oder die Fahrzeuggeschwindigkeit ermittelt. Die Recheneinheit veranlaßt nun z.B. die Ausgabe eines Anzeigebildes eines Tachometers, das der von den Sensoren ermittelten Fahrzeuggeschwindigkeit entspricht. Die Ausgabe erfolgt dabei in der Weise, daß die Einheit zur Dekomprimierung 30 von der Recheneinheit 31 die Anweisung erhält, aus dem Speicher 34 das entsprechende Bild zu dekomprimieren und in den Bildspeicher 32 abzulegen. Der Bildspeicher 32 wird in vorgegebenen Zeitintervallen von der Anzeigeeinheit 33 abgefragt, wobei die in dem Bildspeicher 32 abgelegten Bilddaten in der Anzeigeeinheit 33 zur Anzeige kommen. Die Anzeige 33 ist dabei vorzugsweise eine Flüssigkristallanzeige, kann aber auch ein CRT (Cathod Ray Tube) oder ein FED (Field Emission Display) sein. Während der Bildspeicher 32 vorzugsweise ein flüchtiger Speicher ist, ist der Speicher 34 ein nichtflüchtiger Speicher, so zum Beispiel ein Halbleiterbaustein mit fest gespeicherten Daten bzw. ein magnetischer und/oder optischer Datenträger. Die Vorrichtung zur Dekomprimierung 30 ist vorzugsweise als ein Halbleiterbaustein oder als ein Teil eines Halbleiterbausteins mit einem fest eingespeicherten Programm ausgeführt. Die Ausführung kann sowohl als ein Mikrokontroller als auch ein Mikroprozessor erfolgen.

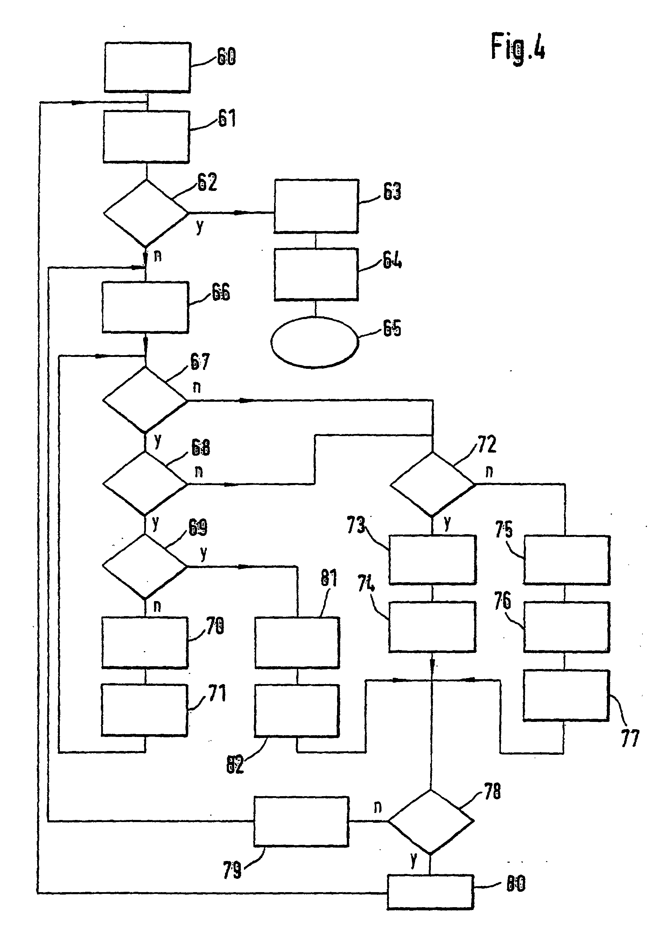

In der Figur 4 ist ein erfindungsgemäßes Verfahren für ein Komprimieren der Daten aus einer Datenfolge dargestellt. In einem ersten Schritt 60 wird das Verfahren initialisiert und die Datenfolge für die Bearbeitung übergeben. Die Datenfolge liegt dabei in einer Form vor, bei der eine eindeutige Reihenfolge der Datenelemente vorgegeben ist. In einem anschließenden zweiten Verfahrensschritt 61 wird ein neuer, erster Bereich eines Datenpaketes initialisiert. Ferner wird als ein aktuelles Datenelement ein erstes Datenelement der Datenfolge festgelegt. Außerdem wird ein erstes Grundelement in dem ersten Bereich des neuen Datenpaketes als aktuelles Grundelement festgelegt. In einem nachfolgenden, ersten Entscheidungsschritt 62 wird überprüft, ob das Ende der Datenfolge erreicht ist. Ist das Ende der Datenfolge erreicht, so wird der mit einem y bezeichnete Verfahrenszweig mit einem Verfahrensschritt 63 weiterverfolgt. In dem Verfahrensschritt 63 wird den noch keinem Wert zugewiesenen Grundelementen in dem ersten Bereich der Wert 1 zugewiesen. In dem nachfolgenden Verfahrensschritt 64 wird den diesen Grundelementen zugehörigen Wörtern in dem ersten Datenelement, in dem der Wiederholungsfaktor für das zweite Datenelement gespeichert ist, der Wert Null und dem zweiten Datenelement der Wert 255 zugewiesen. In einem Abschlußschritt 65 wird das Verfahren beendet und das nunmehr erstellte Datenpaket 10 wird gespeichert. Die Zuweisung in dem Verfahrensschritt 64 ist derartig gewählt, daß die entsprechenden Datenelemente als komprimiert abgelegt gekennzeichnet werden und somit das Datenelement, das dem Wert 255 entspricht, Null Mal wiederholt wird. Bei der Dekomprimierung kann an dieser Stelle geprüft werden, ob das Datenpaket korrekt mit dieser Speicherung abgeschlossen wurde, oder ob möglicherweise eine Beschädigung der Datei vorliegt. Anstelle des Wertes 255 kann auch ein beliebiger Wert für das zweite Datenelement gewählt werden, da dieses Datenelement bei der Dekomprimierung der Datenfolge nicht erscheint. So kann zum Beispiel in dem letzten Wort des letzten Datenpaketes einer komprimierten Datenfolge an dieser Stelle die Gesamtzahl der Datenpakete gespeichert sein, die das Bild ausmacht.

Ist in dem ersten Entscheidungsschritt 62 noch nicht das Ende der Datenfolge erreicht, so wird der mit n bezeichnete Verfahrenszweig weiterverfolgt. In einem nachfolgenden Verfahrensschritt 66 wird nun einem Kompressionszähler der Wert 1 zugewiesen. Der Kompressionszähler dient dazu, die Zahl zu erfassen, wie oft ein Element in der Datenfolge hintereinander wiederholt wird. In einem anschließenden, zweiten Entscheidungsschritt 67 wird überprüft, ob das aktuelle Datenelement gleich einem nächsten Datenelement in der Datenfolge ist. Ist dies der Fall, so wird in den Verfahrenszweig, der mit y bezeichnet ist, zu einem anschließenden, dritten Entscheidungsschritt 68 verzweigt. In dem dritten Entscheidungsschritt 68 wird überprüft, ob der Kompressionszähler kleiner als 255 ist. Ist dies der Fall, so wird der mit y bezeichnete Verfahrenszweig weiterverfolgt und in einem anschließenden, vierten Entscheidungsschritt 69 wird überprüft, ob das übernächste Datenelement in der Datenfolge das letzte Datenelement der Datenfolge ist. Ist dies nicht der Fall, so von dem vierten Entscheidungsschritt 69 aus in den mit n bezeichneten Verfahrenszweig mit einem Verfahrensschritt 70 übergegangen. In dem Verfahrensschritt 70 wird der Kompressionszähler um 1 erhöht. Ferner wird in einem anschließenden Verfahrensschritt 71 das nächste Datenelement der Datenfolge als aktuelles Datenelement festgelegt. Danach wird das Verfahren mit dem zweiten Entscheidungsschritt 67 weitergeführt.

Ist in dem zweiten Entscheidungsschritt 67 das auf das aktuelle Datenelement in der Datenfolge folgende nächste Datenelement ungleich dem aktuellen Datenelement oder hat in dem dritten Entscheidungsschritt 68 der Kompressionszähler einen Wert von größer als 255, so wird das Verfahren mit einem fünften Entscheidungsschritt 72 fortgeführt. In dem fünften Entscheidungsschritt 72 wird überprüft, ob der Kompressionszähler einen Wert größer 1 hat. Ist dies der Fall, so wird in einem Verfahrensschritt 73 das aktuelle Grundelement in dem ersten Bereich des Datenpaketes mit dem Wert 1 belegt. In einem anschließenden Verfahrensschritt 74 wird in dem zu dem Grundelement gehörenden Wort in dem zweiten Bereich des Datenpaketes der Wert des Kompressionszählers in dem ersten Datenelement sowie in dem zweiten Datenelement des zugehörigen Wortes das aktuelle Datenelement aus der Datenfolge gespeichert. Danach wird zu einem sechsten Entscheidungsschritt 78 verzweigt. Hat der Kompressionszähler keinen Wert größer 1, so wird von dem fünften Entscheidungsschritt 72 das aktuelle Grundelement in einem Verfahrensschritt 75 mit dem Wert 0 gespeichert. In einem nächsten Verfahrensschritt 76 wird das aktuelle Datenelement der Datenfolge in dem ersten Datenelement des zu dem in dem Verfahrensschritt 75 gespeicherten Grundelementes gehörenden Wortes gespeichert. Das nächste Datenelement der Datenfolge wird in dem zweiten Datenelement des gleichen Wortes gespeichert. In einem anschließenden Verfahrensschritt 77 wird als aktuelles Datenelement das übernächste Datenelement gewählt. Anschließend wird ebenfalls zu dem sechsten Entscheidungsschritt 78 weiterverzweigt.

Der sechste Entscheidungsschritt 78 wird ebenfalls erreicht, wenn in dem vierten Entscheidungsschritt 69 festgestellt wird, daß das übernächste Datenelement ausgehend von dem aktuellen Datenelement das letzte in der Datenfolge ist. Vor Erreichen des Entscheidungsschritts 78 wird in diesem Fall ausgehend von dem vierten Entscheidungsschritt 69 zunächst in einem Verfahrensschritt 81 das aktuelle Grundelement in dem ersten Bereich des Datenpaketes auf den Wert 1 gesetzt. In einem an diesen Verfahrensschritt 81 anschließenden Verfahrensschritt 82 wird vor Erreichen des sechsten Entscheidungsschritts 78 in dem dazugehörigen Wort in dem ersten Datenelement der Wert 1 und in dem zweiten Datenelemente das zur Speicherung anstehende Datenelement der Datenfolge abgelegt. Anschließend wird ebenfalls zu dem sechsten Entscheidungsschritt 78 verzweigt, in dem überprüft wird, ob das Datenpaket nun vollständig gefüllt ist. Ist dies nicht der Fall, so wird der Verfahrenszweig n gewählt und es wird zu einem Verfahrensschritt 79 verzweigt, in dem als aktuelles Grundelement in dem ersten Bereich des Datenpaketes das nächste, auf das aktuelle Grundelement folgende Grundelement festgelegt. Anschließend wird zu dem Verfahrensschritt 66 verzweigt. Wird dagegen in dem sechsten Entscheidungsschritt 78 festgestellt, daß das Datenpaket vollständig gefüllt ist, wird der Verfahrenszweig y verfolgt und in einem Verfahrensschritt 80 wird das gesamte Datenpaket gespeichert. Anschließend wird zu dem Verfahrensschritt 61 verzweigt und ein nächstes Datenpaket gefüllt.

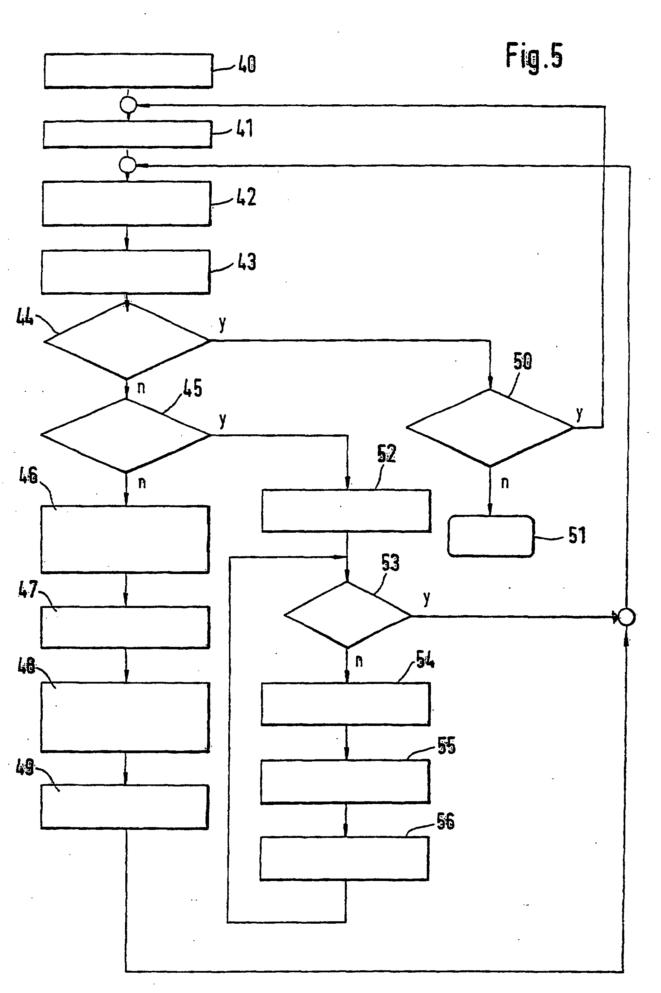

In der Figur 5 ist ein erfindungsgemäßes Verfahren zum Dekomprimieren eines Datenpaketes dargestellt. In einem ersten Verfahrensschritt 40 wird das Verfahren initialisiert und ein Datenpaket wird übergeben. In einem anschließenden, zweiten Verfahrensschritt 41 wird der erste Bereich des Datenpaketes in einem Speicher der Dekomprimiereinheit kopiert bzw. es wird ein Verweis auf den ersten Bereich des Datenpaketes erstellt, das in dem Speicher 34 abgelegt ist. Ferner wird ein Indexzähler auf Null gesetzt. Jedem Wert des Indexzählers, der größer null ist, ist ein Datenelement in dem ersten Bereich des Datenpaketes zugeordnet. Das Grundelement, das dem jeweils vorliegenden Wert des Indexzählers entspricht, ist das jeweils aktuelle Datenelement. In einem nachfolgenden dritten Verfahrensschritt 42 wird der Indexzähler um 1 erhöht. In einem anschließenden Verfahrensschritt 43 wird das zu dem aktuellen Wert des Indexzählers gehörende Grundelement aus dem ersten Bereich des Datenpaketes sowie das zugehörige Wort, also die zwei Datenelemente des Wortes, in den Speicher kopiert, falls ein solches Grundelement bzw. Wort existiert, wobei der Speicher vorteilhafterweise der Dekomprimiervorrichtung 30 zugeordnet ist. In einem nachfolgenden ersten Entscheidungsschritt 44 wird überprüft, ob der Indexzähler die Maximalzahl an Grundelementen pro Datenelement überschritten hat. Ist dies der Fall, so wird in den mit y bezeichneten Verfahrenszweig zu einem zweiten Entscheidungsschritt 50 verzweigt. Hier wird überprüft, ob weitere Datenpakete vorhanden sind. Dies kann zum Beispiel durch einen an jedes Datenpaket angehängten Verweis auf ein folgendes Datenpaket für den Fall, daß ein solches Datenpaket vorhanden ist. Für den Fall, daß kein solches Datenpaket vorhanden ist, ist auch ein Verweis auf ein leeres Datenpaket möglich. Ist ein weiteres Datenpaket vorhanden, so wird zu dem zweiten Verfahrensschritt 41 zurückverzweigt (Verfahrenszweig y von dem zweiten Entscheidungsschritt 50 aus). Ist kein weiteres Datenpaket vorhanden, so wird von dem zweiten Entscheidungsschritt 50 aus in den mit n bezeichneten Verfahrenszweig zu einem Abschlußschritt 51 weiterverzweigt. Die Datenfolge ist somit komplett dekomprimiert und liegt in einem Zwischenspeicher vor. Stellt die Datenfolge ein komprimiertes Bild dar, so ist dieser Zwischenspeicher der Bildspeicher 32 der Anzeigeeinheit 33.

Wird in dem ersten Entscheidungsschritt 44 festgestellt, daß der Indexzähler die Maximalzahl an Grundelementen noch nicht überschritten hat, so wird von dort der mit n bezeichnete Verfahrenszweig zu einem dritten Entscheidungsschritt 45 weiterverfolgt. In diesem dritten Entscheidungsschritt 45 wird überprüft, welchen Wert das aktuelle Grundelement besitzt. Für den Fall, daß es den Wert Null hat, wird in den mit n bezeichneten Verfahrenszweig zu einem Verfahrensschritt 46 weiterverzweigt. In diesem Verfahrensschritt 46 wird das erste Datenelement des zu dem aktuellen Grundelement gehörenden Wortes als ein Element der ursprünglich komprimierten Folge aufgefaßt und einer bis zu diesem Zeitpunkt dekomprimierten Teilfolge hinzugefügt. Beziehen sich die Datenelemente auf Bilddaten, so wird damit das erste Datenelement des zu dem Grundelement gehörenden Wortes in den Bildspeicher 32 der Anzeigeeinheit kopiert. Im Anschluß daran wird in einem Verfahrensschritt 47 eine Zuweisungsadresse für den Bildspeicher erhöht, so daß nachfolgende Datenelemente an einer nachfolgenden Stelle in den Bildspeicher eingeschrieben werden. In einem anschließenden Verfahrensschritt 48 wird das zweite Datenelement des zu dem aktuellen Grundelement gehörenden Wortes in den Bildspeicher kopiert. Im Anschluß wird in einem Verfahrensschritt 49 ebenfalls wieder die Zuweisungsadresse für den Bildspeicher 32 erhöht. Im Anschluß daran wird das Verfahren mit dem zweiten Verfahrensschritt 42 fortgeführt. Wird in dem dritten Entscheidungsschritt 45 festgestellt, daß das aktuelle Grundelement den Wert 1 aufweist, so wird in den mit y bezeichneten Verfahrenszweig zu einem Verfahrensschritt 52 verzweigt. In diesem Verfahrensschritt 52 wird einer Zählvariablen der Wert des ersten Datenelementes des zu dem aktuellen Grundelement gehörenden Wortes zugewiesen. In einem anschließenden vierten Entscheidungsschritt 53 wird überprüft, ob die Zählvariable den Wert Null aufweist. Weist die Zählvariable den Wert Null auf, so wird der mit y bezeichnete Verfahrenszweig weiterverfolgt und es wird ebenso wie nach dem Verfahrensschritt 49 das Verfahren mit dem dritten Verfahrensschritt 42 fortgeführt. Hat die Zählvariable einen Wert ungleich Null, so wird von dem vierten Entscheidungsschritt 53 der mit n bezeichnete Verfahrenszweig fortgeführt. In einem Verfahrensschritt 54 wird das zweite Datenelement des zu dem Grundelement gehörenden Wortes in den Bildspeicher kopiert. In einem anschließenden Verfahrensschritt 55 wird die Zuweisungsadresse des Bildspeichers 32 erhöht. In einem weiteren Verfahrensschritt 56 wird die Zählvariable um 1 erniedrigt. Danach wird das Verfahren mit dem vierten Entscheidungsschritt 53 fortgeführt.

## Patentansprüche

1. Verfahren zur Komprimierung einer Folge von Datenelementen, insbesondere von Bilddaten, wobei die Datenelemente in Abhängigkeit von der Korrelation mit in der Folge der Datenelemente vorhergehenden und nachfolgenden Datenelementen komprimiert oder unkomprimiert abgelegt werden, wobei mindestens ein weiteres Datenelement vorgesehen ist, in dem gespeichert wird, welche der gespeicherten Datenelemente komprimiert oder unkomprimiert abgespeichert werden, **dadurch gekennzeichnet, dass** das Datenelement (15), in dem gespeichert ist, welche Datenelemente (13) komprimiert oder unkomprimiert abgespeichert sind, in einem ersten Speicherbereich (11, 110) abgelegt wird und dass die komprimierten oder unkomprimierten Datenelemente in einem zweiten Speicherbereich (12, 120) abgelegt werden.

2. Verfahren nach Anspruch 1, **dadurch gekennzeichnet, dass** die Folge von Datenelementen in einer vorgegebenen Reihenfolge abgearbeitet wird, indem aufeinanderfolgende Elemente daraufhin überprüft werden, ob sie gleich sind.

3. Verfahren nach einem der vorhergehenden Ansprüche,
**dadurch gekennzeichnet, dass** eine Kompression der Datenelemente dadurch erfolgt, dass Datenelemente, die mehrfach aufeinanderfolgen, gezählt und mit einem Wiederholungsfaktor gespeichert werden.

4. Verfahren nach einem der vorhergehenden Ansprüche,
**dadurch gekennzeichnet, dass** bei Folgen von Datenelementen, die eine vorgebbare Anzahl von Datenelementen überschreiten, die Folge in mehreren Datenpaketen gespeichert wird, wobei jedes Datenpaket aus mindestens zwei Datenelementen besteht.

5. Verfahren zur Dekomprimierung einer Folge von Datenelementen, insbesondere von Bilddaten, aus einem Datenpaket (10, 100), **dadurch gekennzeichnet, dass** das Datenpaket aus Datenelementen in einem ersten (11, 110) und einem zweiten Bereich (12, 120) des Datenpakets besteht, dass die Folge von Datenelementen in Abhängigkeit von den in dem ersten Bereich abgelegten Datenelementen aus den in dem zweiten Bereich abgelegten Datenelemente ohne oder mit einer Dekomprimierung erstellt wird, dass die Datenelemente in dem ersten Bereich aus Grundelementen (15) bestehen und die Daten- und Grundelemente in einer vorgegebenen Reihenfolge abgearbeitet werden, indem jedes Grundelement der in dem ersten Bereich gespeicherten Datenelemente jeweils zwei (14, 24) in dem zweiten Bereich gespeicherten Datenelementen zugewiesen wird, und falls ein Grundelement einen ersten Wert aufweist, keine Dekomprimierung der Datenelemente erfolgt, und falls das Grundelement einen zweiten Wert aufweist eine Dekomprimierung erfolgt.

6. Verfahren zur Dekomprimierung nach Anspruch 5, **dadurch gekennzeichnet, dass** in Abhängigkeit von dem in dem zweiten Bereich des Datenpakets vorliegenden Datenelementen und des nach der vorgegebenen Reihenfolge ersten, zu bearbeitenden Grundelements einer vorgegebenen Teilfolge, insbesondere einer leeren Teilfolge, Datenelemente hinzugefügt werden, und dass die somit erzeugte Teilfolge bei jedem weiteren, zu bearbeitenden Grundelement in Abhängigkeit von den in dem zweiten Bereich des Datenpakets vorliegenden Datenelementen erweitert wird, bis ein Abbruchkriterium erfüllt ist.

7. Verfahren zur Dekomprimierung nach Anspruch 6, **dadurch gekennzeichnet, dass** für den Fall, dass keine Dekomprimierung erfolgt, Datenelemente unverändert an die Teilfolge angefügt werden.

8. verfahren zur Dekomprimierung nach einem der Ansprüche 5-7, **dadurch gekennzeichnet, dass** eine Dekomprimierung derart erfolgt, dass ein erstes, vorgegebenes, dem Grundelement zugewiesenes Datenelement als ein Wiederholungsfaktor für ein zweites, vorgegebenes, dem Grundelement zugewiesenes Datenelement erfasst und das zweite Datenelement entsprechend dem Wiederholungsfaktor an die Teilfolge angefügt wird.

9. Verfahren zur Dekomprimierung nach einem der Ansprüche 5-8, **dadurch gekennzeichnet, dass** eine Dekomprimierung einer Datenfolge aus mehreren, miteinander verknüpften und/oder aufeinanderfolgenden Datenpaketen erfolgt.

10. Vorrichtung zur Dekomprimierung nach einem der vorhergehenden Verfahrensansprüche 5-9, **dadurch gekennzeichnet, dass** die Vorrichtung mit einer Recheneinheit (31) und einer Anzeigevorrichtung (33) verbunden ist, und dass in Abhängigkeit von von der Recheneinheit (31) übermittelter Informationen zumindest teilweise komprimierte Folgen von Datenelementen dekomprimiert und die somit erzeugten Bilddaten an die Anzeigevorrichtung (33), vorzugsweise über einen Bildspeicher (32), übermittelbar sind.

11. Vorrichtung zur Dekomprimierung nach Anspruch 10, **dadurch gekennzeichnet, dass** die Vorrichtung zur Dekomprimierung Teil eines frei programmierbaren Kombiinstruments ist.

## Claims

1. Method for compressing a sequence of data elements, in particular image data, the data elements being stored in compressed or uncompressed form depending on the correlation with preceding and succeeding data elements in the sequence of data elements, at least one further data element being provided, which stores the information as to which of the stored data elements are stored in compressed or uncompressed form, **characterized in that** the data element (15) which stores the information as to which data elements (13) are stored in compressed or uncompressed form is stored in a first memory area (11, 110), and **in that** the compressed or uncompressed data elements are stored in a second memory area (12, 120).

2. Method according to Claim 1, **characterized in that** the sequence of data elements is processed in a predetermined order by successive elements being checked in respect of whether they are identical.

3. Method according to one of the preceding claims, **characterized in that** the data elements are compressed by data elements which multiply succeed one another being counted and stored with a repetition factor.

4. Method according to one of the preceding claims, **characterized in that**, in the case of sequences of data elements which exceed a predeterminable number of data elements, the sequence is stored in a plurality of data packets, each data packet comprising at least two data elements.

5. Method for decompressing a sequence of data elements, in particular image data, from a data packet (10, 100), **characterized in that** the data packet comprises data elements in a first (11, 110) and a second area (12, 120) of the data packet, **in that** the sequence of data elements is created from the data elements stored in the second area, without or with decompression, depending on the data elements stored in the first area, **in that** the data elements in the first area comprise basic elements (15) and the data elements and basic elements are processed in a predetermined order by each basic element of the data elements stored in the first area being allocated in each case to two (14, 24) data elements stored in the second area, and if a basic element has a first value, the data elements are not decompressed, and if the basic element has a second value, decompression is effected.

6. Method for decompression according to Claim 5, **characterized in that**, depending on the data elements present in the second area of the data packet and on the first basic element to be processed according to the predetermined order, data elements are added to a predetermined subsequence, in particular an empty subsequence, and **in that** the subsequence thus generated is extended, in the case of each further basic element to be processed, depending on the data elements in the second area of the data packet, until a termination criterion is fulfilled.

7. Method for decompression according to Claim 6, **characterized in that**, for the case where no decompression is effected, data elements are added unchanged to the subsequence.

8. Method for decompression according to one of Claims 5-7, **characterized in that** decompression is effected in such a way that a first predetermined data element allocated to the basic element is acquired as a repetition factor for a second predetermined data element allocated to the basic element and the second data element is added to the subsequence in accordance with the repetition factor.

9. Method for decompression according to one of Claims 5-8, **characterized in that** decompression of a data sequence is effected from a plurality of data packets that are combined with one another and/or succeed one another.

10. Device for compression according to one of the preceding Method Claims 5-9, **characterized in that** the device is connected to a computing unit (31) and a display device (33), and **in that**, depending on information communicated by the computing unit (31), at least partly compressed sequences of data elements are decompressed and the image data thus generated can be communicated to the display device (33), preferably via an image memory (32).

11. Device for decompression according to Claim 10, **characterized in that** the device for decompression is part of a freely programmable combination instrument.

## Revendications

1. Procédé de compression d'une suite d'éléments de données, notamment de données d'image, selon lequel les éléments de données sont placés comprimés ou décomprimés en fonction de la corrélation avec des éléments de données en amont ou en aval dans la suite des éléments de données,
au moins un autre élément de données étant prévu dans lequel on enregistre quels éléments de données mis en mémoire sont à extraire comprimés ou décomprimés,
**caractérisé en ce que**
l'élément de données (15) dans lequel on enregistre quels éléments de données (13) sont comprimés ou décomprimés, est placé dans une première zone de mémoire (11, 110), et
les éléments de données comprimés ou décomprimés sont placés dans une seconde zone de mémoire (12, 120).

2. Procédé selon la revendication 1,
**caractérisé en ce que**
la suite des éléments de données est traitée dans un ordre prédéterminé dans lequel on vérifie les éléments successifs pour déterminer s'ils sont identiques.

3. Procédé selon l'une quelconque des revendications précédentes,
**caractérisé par**
une compression des éléments de données, telle que les éléments de données qui se suivent plusieurs fois soient comptés et enregistrés avec un coefficient de répétition.

4. Procédé selon l'une quelconque des revendications précédentes,
**caractérisé en ce que**
pour des suites d'éléments de données qui dépassent un nombre prédéterminé d'éléments de données, on enregistre la suite dans plusieurs paquets de données et chaque paquet de données se compose d'au moins deux éléments de données.

5. Procédé de décompression d'une suite d'éléments de données notamment de données d'image d'un paquet de données (10, 100),
**caractérisé en ce que**
le paquet de données de compose d'éléments de données d'une première zone (11,110) et d'une seconde zone (12, 120) du paquet de données, on règle la suite d'éléments de données en fonction des éléments de données enregistrés dans la première zone à partir des éléments de données enregistrés dans la seconde zone sans ou avec décompression, les éléments de données de la première zone se composent d'éléments de base (15) et les éléments de données et les éléments de base sont traités dans un ordre prédéterminé en attribuant chaque fois deux éléments de données (14, 24) enregistrés dans la seconde zone à chaque élément de base des éléments de données enregistrés dans la première zone, et au cas où un élément de base présente une première valeur, on ne décomprime pas les éléments de données et dans le cas où l'élément de base comporte une seconde valeur, on effectue une décompression.

6. Procédé de décompression selon la revendication 5,
**caractérisé en ce qu'**
en fonction des éléments de données qui existent dans la seconde zone du paquet de données et du premier élément de base à traiter après la suite prédéterminée, notamment d'une suite vide, on ajoute des éléments de données et la suite partielle ainsi générée est étendue à chaque autre élément de base à traiter, en fonction des éléments de données existant dans la seconde zone du paquet de données, jusqu'à ce qu'un critère d'arrêt soit rempli.

7. Procédé de décompression selon la revendication 6,
**caractérisé en ce qu'**
au cas où il n'y a pas de décompression, les éléments de données sont insérés, inchangés dans la suite partielle.

8. Procédé de décompression selon l'une quelconque des revendications 5 à 7,
**caractérisé en ce qu'**
on effectue une décompression de façon qu'un premier élément de données prédéterminé associé à l'élément de base soit saisi comme coefficient de répétition d'un second élément de données prédéterminé associé à l'élément de base et le second élément de données est ajouté à la suite partielle en fonction du coefficient de répétition.

9. Procédé dé décompression selon l'une quelconque des revendications 5 à 8,
**caractérisé en ce qu'**
on effectue une décompression d'une suite de données de plusieurs paquets de données combinés et/ou successifs.

10. Dispositif de décompression selon l'une quelconque des revendications précédentes de procédé 5 à 9,
**caractérisé en ce que**
le dispositif est relié à une unité de calcul (31) et à un dispositif d'affichage (33) et en fonction des informations transmises par l'unité de calcul (31), on décomprime les informations transmises, correspondant aux suites partiellement comprimées d'éléments de données et les données d'image ainsi obtenues sont transmises au dispositif d'affichage (33) de préférence par une mémoire d'image (32).

11. Dispositif de décompression selon la revendication 10,
**caractérisé en ce qu'**
il fait partie d'un instrument combiné programmable librement.
